# EUROPEAN PATENT APPLICATION

(11) **EP 4 626 156 A1**
(43) Date of publication of application: **01.10.2025**
(21) Application number: 25163227.9
(22) Date of filing: 12.03.2025
(51) Int. Cl.: H05K 7/14, H01R 13/645

(54) **AUTOMATION CONTROL SYSTEM COMPONENTS WITH ERROR PROOF ELECTRONIC KEYING FEATURES**

(30) Priority: 26.03.2024 US 202418617306
(71) Applicant: Rockwell Automation Asia Pacific Business Center Pte. Ltd., Singapore 618494 (SG)
(72) Inventor: Zhang, Rain Jilin, 618494 Singapore (SG); Kang, Soon Seng, 618494 Singapore (SG); Mahalingam, Karthikeyan, 618494 Singapore (SG)
(74) Representative: Grünecker Patent- und Rechtsanwälte PartG mbB

(57) **Abstract**

A system may include a terminal block having a plurality of slots on a first side of the terminal block, such that each of the plurality of slots is configured to receive an insert. The system may also include an input/output (I/O) device comprising a circuit, such that the circuit may include one or more indentations that may receive one or more inserts positioned in one or more slots of the plurality of slots.

## Description

### BACKGROUND

The present disclosure relates generally to the field of automation control systems, such as those used in industrial and commercial settings. More particularly, embodiments of the present invention relate to techniques for providing, accessing, configuring, operating, or interfacing with input/output (I/O) devices that are configured for coupling and interaction with an automation controller.

Automation controllers are special purpose computers used for controlling industrial automation and the like. Under the direction of stored programs, a processor of the automation controller examines a series of inputs (e.g., electrical input signals to the automation controller) reflecting the status of a controlled process and changes outputs (e.g., electrical output signals from the automation controller) based on analysis and logic for affecting control of the controlled process. The stored control programs may be continuously executed in a series of execution cycles, executed periodically, or executed based on events. The inputs received by the automation controller from the controlled process and the outputs transmitted by the automation controller to the controlled process are normally passed through one or more I/O devices, which are components of an automation control system that serve as an electrical interface between the automation controller and the controlled process.

Traditional I/O devices typically include a base configured to couple the I/O device with a bus bar or the like, a terminal block for communicatively coupling the I/O device with field devices, an I/O module that includes circuitry for performing communication functions and/or logic operations, and the like. During maintenance of the I/O devices, the I/O modules and/or the terminal blocks of the I/O devices may be removed from their respective bases to facilitate performing diagnostics and troubleshooting of the I/O devices. Sometimes, when the I/O modules and/or the terminal blocks are re-inserted into their respective bases (e.g., once maintenance has been completed), one or more of the I/O modules and/or terminal blocks may be inadvertently re-inserted into a base for which it was not intended. As such, inadvertent mismatches of I/O modules and terminal blocks may occur. As a result, unexpected control issues may arise due to such mismatches. It is now recognized that it is desirable to provide reliable features for preventing such inadvertent insertion of I/O modules and/or terminal blocks into bases to which they are not intended.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

In one embodiment, a system may include a terminal block having a plurality of slots on a first side of the terminal block, such that each of the plurality of slots is configured to receive an insert. The system may also include an input/output (I/O) device comprising a circuit, such that the circuit may include one or more indentations that may receive one or more inserts positioned in one or more slots of the plurality of slots.

### BRIEF DESCRIPTION OF THE DRAWINGS

These and other features, aspects, and advantages of the present invention will become better understood when the following detailed description is read with reference to the accompanying drawings in which like characters represent like parts throughout the drawings, wherein:
FIG. 1 illustrates an example industrial automation system employed by a food manufacturer, in accordance with an embodiment;
FIG. 2 illustrates a diagrammatical representation of an exemplary control and monitoring system that may be employed in any suitable industrial automation system, in accordance with an embodiment;
FIG. 3 is a perspective view of a plurality of I/O devices connected to an I/O adapter, in accordance with an embodiment;
FIG. 4 is a perspective view of a housing of an exemplary I/O device, in accordance with an embodiment;
FIG. 5 is a perspective view of a circuit disposed within the housing of the exemplary I/O device, in accordance with an embodiment;
FIG. 6 is a perspective view of a terminal block and a key component for use with the exemplary I/O device, in accordance with an embodiment;
FIG. 7 is a perspective view of a terminal block and an insert of the key component placed within a terminal of the terminal block for use with the exemplary I/O device, in accordance with an embodiment;
FIG. 8 is a perspective view of a terminal block and an insert of the key component positioned within the terminal of the terminal block for use with the exemplary I/O device, in accordance with an embodiment;
FIG. 9 is a perspective view of the housing of the exemplary I/O device being coupled with a base of the I/O device, in accordance with an embodiment;
FIG. 10 is a perspective view of the terminal block of the exemplary I/O device being coupled with a housing of the I/O device, in accordance with an embodiment; and
FIG. 11 is a perspective view of the terminal block of the exemplary I/O device being coupled to the circuit device within the housing of the I/O device, in accordance with an embodiment.

### DETAILED DESCRIPTION

One or more specific embodiments will be described below. In an effort to provide a concise description of these embodiments, not all features of an actual implementation are described in the specification. It should be appreciated that in the development of any such actual implementation, as in any engineering or design project, numerous implementation- specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," "the," and "said" are intended to mean that there are one or more of the elements. The terms "comprising," "including," and "having" are intended to be inclusive and mean that there may be additional elements other than the listed elements. As used herein, the terms "container nodes," "host devices," and "container hosts" may be used interchangeably. One or more specific embodiments of the present embodiments described herein will be described below. In an effort to provide a concise description of these embodiments, all features of an actual implementation may not be described in the specification.

As mentioned above, I/O modules or terminal blocks may be coupled to a base to allow I/O devices to communicatively couple to other devices, such as automation controllers, control systems, and the like. In some embodiments, the I/O terminal block may include a number of terminals or pins (e.g., 18) in which a respective I/O device may access to communicate with other devices (e.g., sensors), receive power, and the like. That is, each different I/O device may use different pins or terminals (e.g., channels) to perform its respective operations. In some embodiments, one or more of the pins of the I/O terminal block may not be used by the respective device. With this in mind, these unused pins may receive a key component that disables or blocks access to the respective pin or terminal.

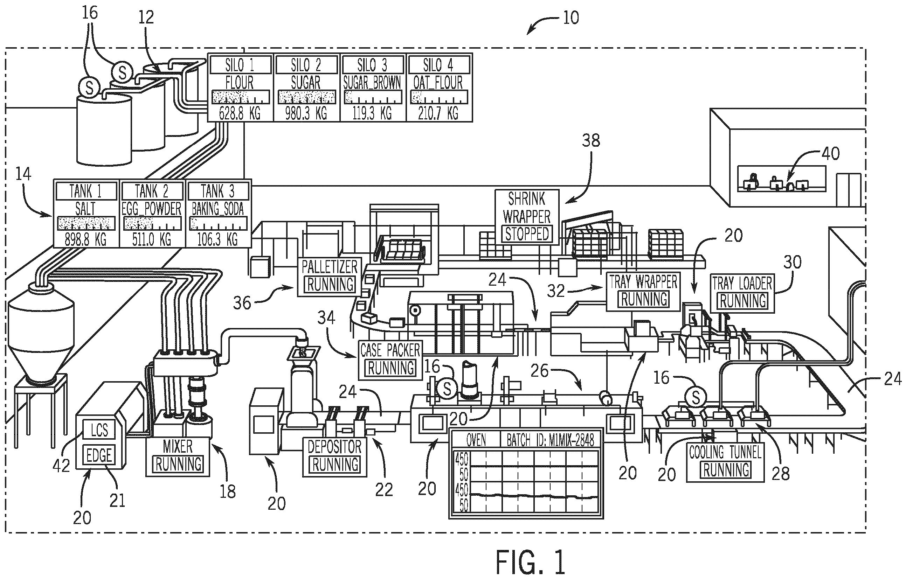

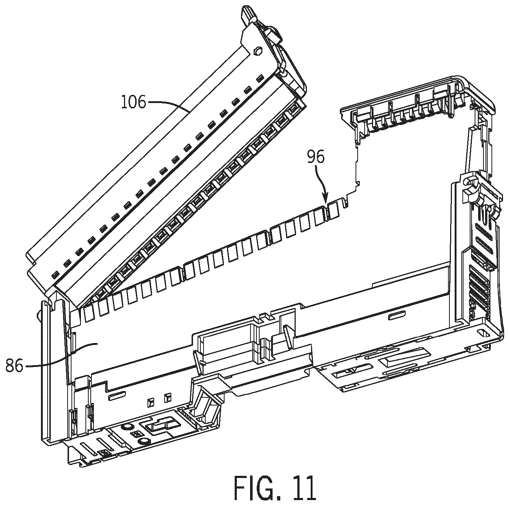

In some embodiments, the terminal block may be mechanically and electrically coupled to a housing that includes a circuit device (e.g., printed circuit board). Each particular individual I/O device may include a particular circuit device that be manufactured such that its electrical connections (e.g., board-to-board connectors) mechanically and electrically couple to the respective terminal block. However, each respective circuit device may include a notch, recessed portion, or indentation that may accommodate the key component inserted into a respective pin of a terminal block that may be coupled to the housing. As such, by way of operation, in order for certain terminal blocks to connect to the housing of a respective I/O device, key components should be placed in certain terminals to enable the terminal block to mechanically connect to the respective circuit device. Indeed, if the key component is incorrectly positioned in an incorrect terminal of the terminal block, the inserted key component may prevent the terminal block from mechanically and electrically coupling to the respective circuit device. In this way, when terminal blocks of the I/O devices are removed during maintenance of the I/O devices, the terminal blocks may not connect to respective base of an I/O device unless it has the key components positioned in the appropriate positions. As a result, the key components provide an improved system and method for error-proofing the connection of terminal blocks to respective circuit devices. Additional details regarding the present embodiments described above will be detailed below with reference to FIGS. 1-11.

By way of introduction, FIG. 1 illustrates an example industrial automation system 10 employed by a food manufacturer. It should be noted that although the example industrial automation system 10 of FIG. 1 is directed at a food manufacturer, the present embodiments described herein may be employed within any suitable industry, such as automotive, mining, hydrocarbon production, manufacturing, and the like. The following brief description of the example industrial automation system 10 employed by the food manufacturer is provided herein to help facilitate a more comprehensive understanding of how the embodiments described herein may be applied to industrial devices to significantly improve the operations of the respective industrial automation system. As such, the embodiments described herein should not be limited to be applied to the example depicted in FIG. 1.

Referring now to FIG. 1, the example industrial automation system 10 for a food manufacturer may include silos 12 and tanks 14. The silos 12 and the tanks 14 may store different types of raw material, such as grains, salt, yeast, sweeteners, flavoring agents, coloring agents, vitamins, minerals, and preservatives. In some embodiments, sensors 16 may be positioned within or around the silos 12, the tanks 14, or other suitable locations within the industrial automation system 10 to measure certain properties, such as temperature, mass, volume, pressure, humidity, and the like.

The raw materials may be provided to a mixer 18, which may mix the raw materials together according to a specified ratio. The mixer 18 and other machines in the industrial automation system 10 may employ certain industrial automation devices 20 to control the operations of the mixer 18 and other machines. The industrial automation devices 20 may include controllers, input/output (I/O) modules, motor control centers, motors, human machine interfaces (HMIs), operator interfaces, contactors, starters, sensors 16, actuators, conveyors, drives, relays, protection devices, switchgear, compressors, sensor, actuator, firewall, network switches (e.g., Ethernet switches, modular-managed, fixed-managed, service-router, industrial, unmanaged, etc.) and the like.

The mixer 18 may provide a mixed compound to a depositor 22, which may deposit a certain amount of the mixed compound onto conveyor 24. The depositor 22 may deposit the mixed compound on the conveyor 24 according to a shape and amount that may be specified to a control system for the depositor 22. The conveyor 24 may be any suitable conveyor system that transports items to various types of machinery across the industrial automation system 10. For example, the conveyor 24 may transport deposited material from the depositor 22 to an oven 26, which may bake the deposited material. The baked material may be transported to a cooling tunnel 28 to cool the baked material, such that the cooled material may be transported to a tray loader 30 via the conveyor 24. The tray loader 30 may include machinery that receives a certain amount of the cooled material for packaging. By way of example, the tray loader 30 may receive 25 ounces of the cooled material, which may correspond to an amount of cereal provided in a cereal box.

A tray wrapper 32 may receive a collected amount of cooled material from the tray loader 30 into a bag, which may be sealed. The tray wrapper 32 may receive the collected amount of cooled material in a bag and seal the bag using appropriate machinery. The conveyor 24 may transport the bagged material to case packer 34, which may package the bagged material into a box. The boxes may be transported to a palletizer 36, which may stack a certain number of boxes on a pallet that may be lifted using a forklift or the like. The stacked boxes may then be transported to a shrink wrapper 38, which may wrap the stacked boxes with shrink-wrap to keep the stacked boxes together while on the pallet. The shrink-wrapped boxes may then be transported to storage or the like via a forklift or other suitable transport vehicle.

To perform the operations of each of the devices in the example industrial automation system 10, the industrial automation devices 20 may be used to provide power to the machinery used to perform certain tasks, provide protection to the machinery from electrical surges, prevent injuries from occurring with human operators in the industrial automation system 10, monitor the operations of the respective device, communicate data regarding the respective device to a supervisory control system 40, and the like. In some embodiments, each industrial automation device 20 or a group of industrial automation devices 20 may be controlled using a local control system 42. The local control system 42 may include receive data regarding the operation of the respective industrial automation device 20, other industrial automation devices 20, user inputs, and other suitable inputs to control the operations of the respective industrial automation device(s) 20.

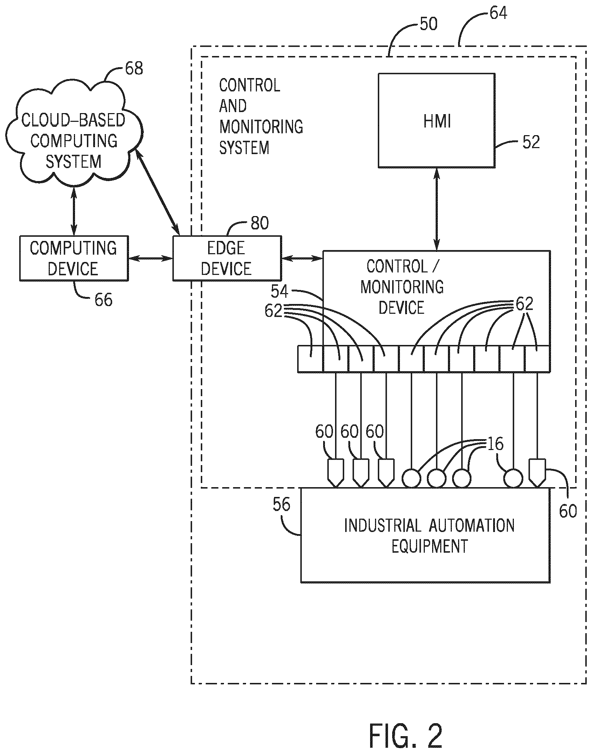

By way of example, FIG. 2 illustrates a diagrammatical representation of an exemplary control and monitoring system 50 that may be employed in any suitable industrial automation system 10, in accordance with embodiments presented herein. In FIG. 2, the control and monitoring system 50 is illustrated as including a human machine interface (HMI) 52 and a control/monitoring device 54 or automation controller adapted to interface with devices that may monitor and control various types of industrial automation equipment 56. By way of example, the industrial automation equipment 56 may include the mixer 18, the depositor 22, the conveyor 24, the oven 26, and the other pieces of machinery described in FIG. 1.

It should be noted that the HMI 52 and the control/monitoring device 54, in accordance with embodiments of the present techniques, may be facilitated by the use of certain network strategies. Indeed, an industry standard network may be employed, such as DeviceNet, to enable data transfer. Such networks permit the exchange of data in accordance with a predefined protocol, and may provide power for operation of networked elements.

As discussed above, the industrial automation equipment 56 may take many forms and include devices for accomplishing many different and varied purposes. For example, the industrial automation equipment 56 may include machinery used to perform various operations in a compressor station, an oil refinery, a batch operation for making food items, a mechanized assembly line, and so forth. Accordingly, the industrial automation equipment 56 may comprise a variety of operational components, such as electric motors, valves, actuators, temperature elements, pressure sensors, or a myriad of machinery or devices used for manufacturing, processing, material handling, and other applications.

Additionally, the industrial automation equipment 56 may include various types of equipment that may be used to perform the various operations that may be part of an industrial application. For instance, the industrial automation equipment 56 may include electrical equipment, hydraulic equipment, compressed air equipment, steam equipment, mechanical tools, protective equipment, refrigeration equipment, power lines, hydraulic lines, steam lines, and the like. Some example types of equipment may include mixers, machine conveyors, tanks, skids, specialized original equipment manufacturer machines, and the like. In addition to the equipment described above, the industrial automation equipment 56 may be made up of certain automation devices 20, which may include controllers, input/output (I/O) modules or devices, motor control centers, motors, human machine interfaces (HMIs), operator interfaces, contactors, starters, sensors 16, actuators, drives, relays, protection devices, switchgear, compressors, firewall, network switches (e.g., Ethernet switches, modular-managed, fixed-managed, service-router, industrial, unmanaged, etc.) and the like.

In certain embodiments, one or more properties of the industrial automation equipment 56 may be monitored and controlled by certain equipment for regulating control variables used to operate the industrial automation equipment 56. For example, the sensors 16 and actuators 60 may monitor various properties of the industrial automation equipment 56 and may adjust operations of the industrial automation equipment 56, respectively.

In some cases, the industrial automation equipment 56 may be associated with devices used by other equipment. For instance, scanners, gauges, valves, flow meters, and the like may be disposed on industrial automation equipment 56. Here, the industrial automation equipment 56 may receive data from the associated devices and use the data to perform their respective operations more efficiently. For example, a controller (e.g., control/monitoring device 54) of a motor drive may receive data regarding a temperature of a connected motor and may adjust operations of the motor drive based on the data.

In certain embodiments, the industrial automation equipment 56 may include a communication component that enables the industrial equipment 56 to communicate data between each other and other devices. The communication component may include a network interface that may enable the industrial automation equipment 56 to communicate via various protocols such as Ethernet/IP^{®}, ControlNet^{®}, DeviceNet^{®}, or any other industrial communication network protocol. Alternatively, the communication component may enable the industrial automation equipment 56 to communicate via various wired or wireless communication protocols, such as Wi-Fi, mobile telecommunications technology (e.g., 2G, 3G, 4G, 5G, LTE), Bluetooth^{®}, near-field communications technology, and the like.

The sensors 16 may be any number of devices adapted to provide information regarding process conditions. The actuators 60 may include any number of devices adapted to perform a mechanical action in response to a signal from a controller (e.g., the control/monitoring device 54). The sensors 16 and actuators 60 may be utilized to operate the industrial automation equipment 56. Indeed, they may be utilized within process loops that are monitored and controlled by the control/monitoring device 54 and/or the HMI 52. Such a process loop may be activated based on process inputs (e.g., input from a sensor 16) or direct operator input received through the HMI 52. As illustrated, the sensors 16 and actuators 60 are in communication with the control/monitoring device 54. Further, the sensors 16 and actuators 60 may be assigned a particular address in the control/monitoring device 54 and receive power from the control/monitoring device 54 or attached modules.

Input/output (I/O) modules or devices 62 may be added or removed from the control and monitoring system 50 via expansion slots, bays or other suitable mechanisms in accordance with embodiments described herein. In certain embodiments, the I/O modules 62 may be included to add functionality to the control/monitoring device 54, or to accommodate additional process features. For instance, the I/O modules 62 may communicate with new sensors 16 or actuators 60 added to monitor and control the industrial automation equipment 56. It should be noted that the I/O modules 62 may communicate directly to sensors 16 or actuators 60 through hardwired connections or may communicate through wired or wireless sensor networks, such as Hart or IOLink.

Generally, the I/O modules 62 serve as an electrical interface to the control/monitoring device 54 and may be located proximate or remote from the control/monitoring device 54, including remote network interfaces to associated systems. In such embodiments, data may be communicated with remote modules over a common communication link, or network, wherein modules on the network communicate via a standard communications protocol. Many industrial controllers can communicate via network technologies such as Ethernet (e.g., IEEE802.3, TCP/IP, UDP, Ethernet/IP, and so forth), ControlNet, DeviceNet or other network protocols (Foundation Fieldbus (H1 and Fast Ethernet) Modbus TCP, Profibus) and also communicate to higher level computing systems.

In the illustrated embodiment, several of the I/O modules 62 may transfer input and output signals between the control/monitoring device 54 and the industrial automation equipment 56. As illustrated, the sensors 16 and actuators 60 may communicate with the control/monitoring device 54 via one or more of the I/O modules 62 coupled to the control/monitoring device 54.

In certain embodiments, the control/monitoring system 50 (e.g., the HMI 52, the control/monitoring device 54, the sensors 16, the actuators 60, the I/O modules 62) and the industrial automation equipment 56 may make up an industrial automation application 64. The industrial automation application 64 may involve any type of industrial process or system used to manufacture, produce, process, or package various types of items. For example, the industrial applications 64 may include industries such as material handling, packaging industries, manufacturing, processing, batch processing, the example industrial automation system 10 of FIG. 1, and the like.

In certain embodiments, the control/monitoring device 54 may be communicatively coupled to a computing device 66 and a cloud-based computing system 68. In this network, input and output signals generated from the control/monitoring device 54 may be communicated between the computing device 66 and the cloud-based computing system 68. Although the control/monitoring device 54 may be capable of communicating with the computing device 66 and the cloud-based computing system 68, as mentioned above, in certain embodiments, the control/monitoring device 54 (e.g., local computing system 42) may perform certain operations and analysis without sending data to the computing device 66 or the cloud-based computing system 68.

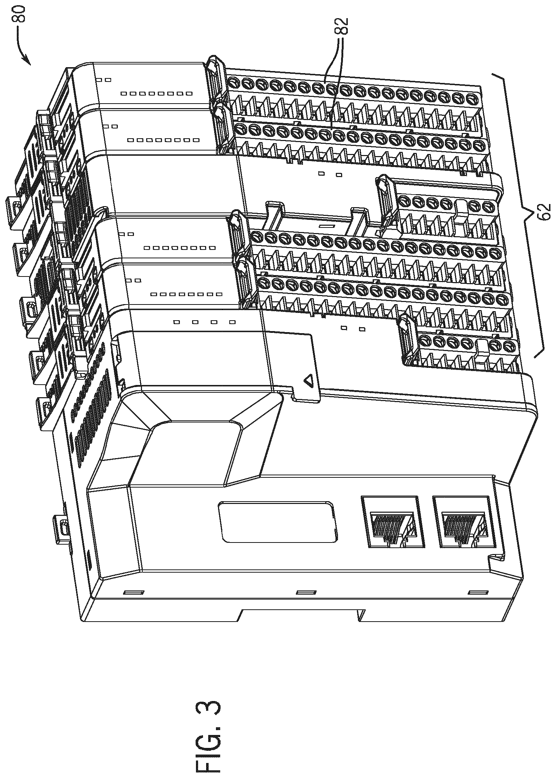

With the foregoing in mind, as mentioned above, the I/O modules 62 may be coupled to the control/monitoring device 54 via bays, electrical slots, expansion slots, and the like. By way of example, FIG. 3 illustrates a perspective view of a I/O module system 80 that may include a number of I/O modules 62. As illustrated, each I/O module 62 may include terminal blocks 82 that may couple to wires or other electrical components.

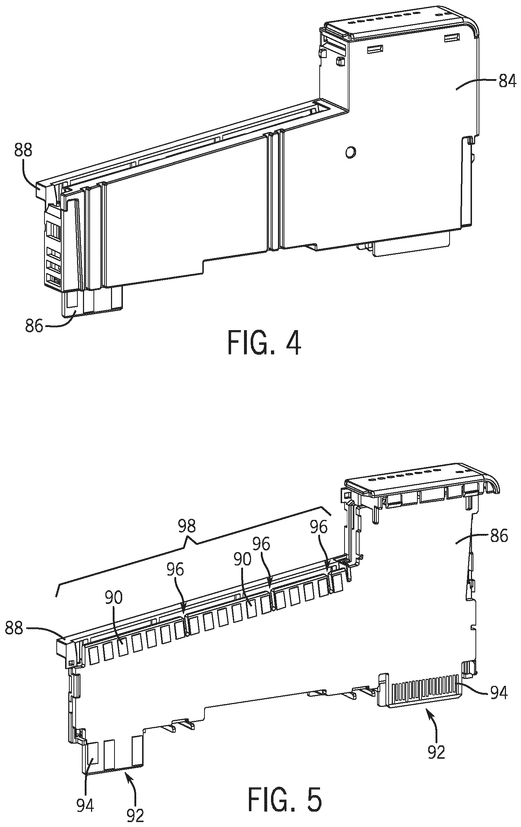

In some embodiments, the I/O module 62 may include a housing 84 that may enclose or surround a circuit device 86, as shown in FIGS. 4 and 5, respectively. The housing 84 may be composed of plastic, metal, or other suitable material to protect the circuit device 86. In some embodiments, the housing 84 may include a receptacle 88 that may position the circuit device 86 therebetween.

The circuit device 86 may be a circuit board (e.g., printed circuit board) or another suitable piece of circuitry. In some embodiments, the circuit device 86 may include electrical connectors 90 (e.g., trace ends, board-to-board connectors) that may be positioned in the center or within the receptacle 88. The circuit device 86 may also include protrusions 92 that may be inserted or positioned within a bay, socket, slot, additional receptacle, or the like to connect to devices coupled to the I/O module system 80. The protrusions 92 may also include electrical connectors 94 that electrically couple to the control/monitoring device 54, the industrial automation equipment 56, or the like.

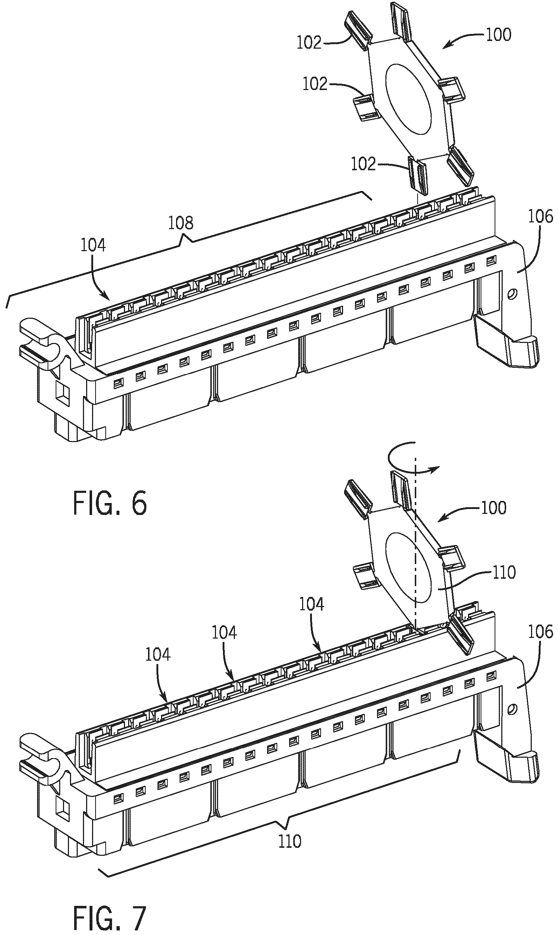

Referring closely to FIG. 5, the circuit device 86 may include one or more indentations 96 (e.g., recess portions) along a side 98 of the circuit device 86 where the electrical connectors 90 are positioned. As will be appreciated, the indentations 96 may have dimensions (e.g., length, width, height) that corresponds to dimensions of a key insert of a key component depicted in FIG. 6. Referring briefly to FIG. 6, a key component 100 may include a number of key inserts 102, such that an individual key insert 102 may be placed within a slot 104 of a terminal block 106. The terminal block 106 may include any suitable number (e.g., 10, 16, 18, 20) of slots 104 on a first side 108 of the terminal block 106. As mentioned above, the key insert 102 may have substantially similar or the same dimensions as an individual slot 104, such that the key insert securely fits within the slot 104. By way of example, the key insert 102 may have a rectangular or square shape that matches the dimensions of the slot 104. In some embodiments, when placed in the slot 104, the key insert 104 may be affixed or mechanically secured within the slot by mechanical fasteners or the like. In some embodiments, the key insert 102 may be affixed or retained in the slot 104 using an interference-fit technique or arrangement or other suitable manner.

By way of operation, the key insert 102 of the key component 100 may be inserted into a particular slot and the key component 100 may be rotated about an axis that corresponds to the slot 104 in which the key insert 102 is placed until the key insert 102 breaks off of the key component 100. As such, the key insert 102 may be coupled to a body 110 of the key component 100 with a less dense or thinner portion of material that makes up the key insert 102 and the key component 100. That is, the key insert 102 and they key component 100 may be composed of a plastic or other suitable material that may have a thicker or more dense amount of material within the key insert 102 and the body 110 of the key component 100, as compared to a portion of material disposed between the key insert 102 and the body 110 of the key component 100. In this way, the twisting or turning motion of the key component 100 while the key insert 102 is positioned in the slot 104 may cause the key insert 102 to break free from the body 110 of the key component 100. It should be noted that the key insert 102 may be broken off or removed from the key component 100 in other manners and the twist/turn embodiment amounts to just one suitable embodiment.

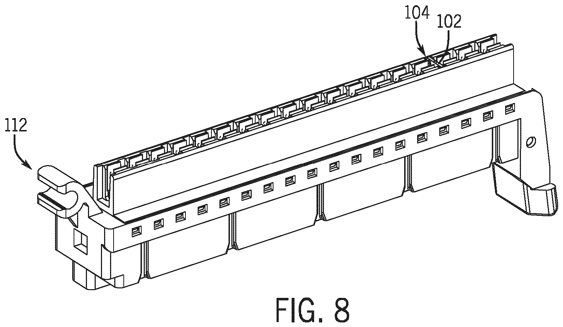

After the key insert 102 is broken or removed from the key component 100, the key insert 102 may be positioned in the slot 104 as shown in FIG. 8. As mentioned above, the key insert 102 may be securely fastened or positioned within the slot 104 to prevent the key insert 102 from falling out when the terminal block 106 is rotated or affixed to the housing 84. In some embodiments, the

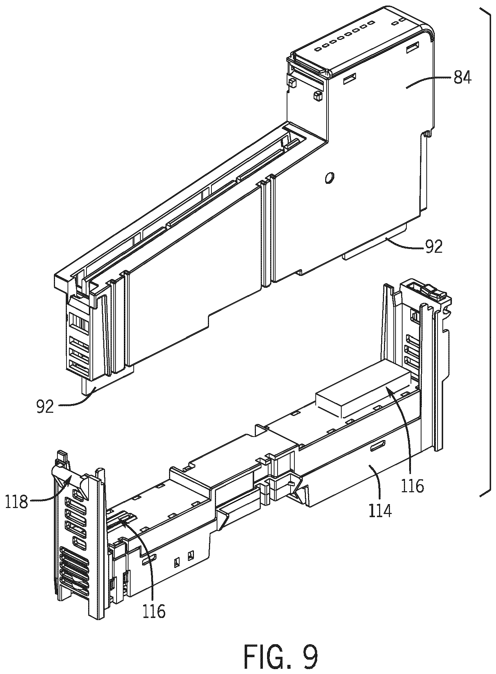

Each of the slots 104 may be positioned such that it aligns with one of the electrical connectors 90 of the side 98 of the circuit device 86. That is, the side 108 of the terminal block 106 may be coupled or affixed to the side 98 of the circuit device 86 via the receptacle 88. With this in mind, a side 110 (e.g., opposite of side 108) of the terminal block 106 may include terminals that may electrically couple to the electrical connectors 90 of the circuit device 86 after the terminal block 106 is inserted into the receptacle 88. By way of example, the terminal block 106 may include a rotational coupling element 112 that may be mechanically coupled to a coupling feature that may be part of the housing 84 or a base of the I/O module 62. The rotational coupling element 112 may have a circular shape with an aperture or empty portion of the circle to enable the rotational coupling element 112 to mechanically couple to a corresponding cylindrical element, as will be detailed below with reference to FIGS. 9-11. Although the terminal block 106 is described as including a rotational coupling element 112, it should be noted that any suitable coupling element may be employed in accordance with embodiments described herein and should not be limited to the rotational coupling element 112 illustrated herein.

FIG. 9 illustrates the housing 84 of the I/O module 62 aligned with a base 114 of the I/O module 62. The base 114 may be a mechanical structure with a coupling feature (e.g., that may couple to a rail (e.g., DIN rail) within an industrial system 10. The base 114 may include electrical slots 116 that electrically and mechanically couple to the electrical connectors 94. That is, the electrical slots 116 may have dimensions that enable protrusions 92 having the electrical connectors 94 to position themselves into the available empty spaces of the electrical slots 116 while making an electrical connection to the base 114 and other devices that may be connected to the base 114. Moreover, the insertion of the protrusions 92 into the electrical slots 116 may securely fasten the electrical connectors 94 to corresponding electrical connectors of the base 114, and thus connecting the circuit device 86 to the base 114.

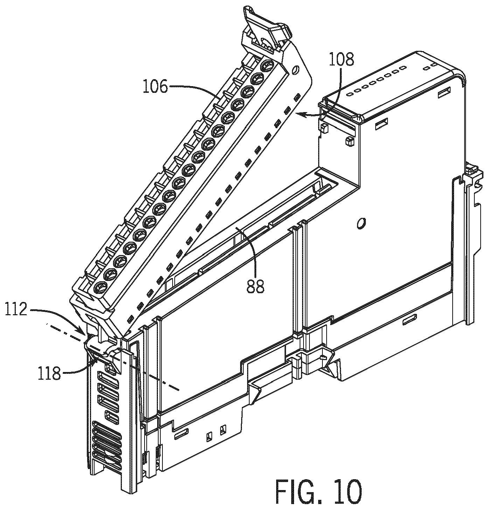

In addition to the electrical slots 116, the base 114 may include a fixed cylindrical element 118 that may mechanically couple to the rotational coupling element 112, as discussed above. Referring to FIG. 10, the rotational coupling element 112 may be inserted (e.g., via missing circular portion) into the fixed cylindrical element 118. As such, the diameter of the fixed cylindrical element 118 may substantially match or be the same as the diameter of the circular shape of the rotational coupling element 112.

After the rotational coupling element 112 is inserted into the fixed cylindrical element 118, the rotational coupling element 112 may rotate about an axis that corresponds to the fixed cylindrical element 118. In this arrangement, the side 108 of the terminal block 106 may be positioned such that it rotates and aligns to be placed into the receptacle 88. As such, the terminal block 106 may be securely fastened to the housing 84 and the circuit device 86. However, it should be noted that the terminal block 106 may not be able to fasten to the housing 84 and the circuit device 86 if one or more key inserts 102 are positioned in one or more slots 104 that do not match the indentations 96 of the respective circuit device 86. That is, as mentioned above, each unique I/O module 62 may be associated with a unique circuit device 86 that performs certain functions and designates different electrical connectors 90 to different channels, devices, and the like.

With this in mind, to ensure that the correct or matching terminal block 106 is coupled to a corresponding circuit device 86, the key inserts 102 should be positioned in slots 104 that correspond to the indentations 96 of the corresponding circuit device 86. By way of example, different types of I/O modules 62 may have different positions for indentations 96 to be located along their respective circuit devices 86. In turn, before coupling the terminal block 106 to the housing 84 and the circuit device 86, key inserts 102 may be placed into slots 104 that correspond to the respective circuit device 86 of the respective I/O module 62. In this way, after removing terminal blocks 106 from I/O module systems 80 (e.g., FIG. 1) to perform maintenance operations or the like, terminal blocks 106 that were previously coupled to a particular I/O module 62 cannot be coupled to another I/O module 62 unless the key inserts 102 are positioned in the slots 104 that match the indentations 96 of the respective circuit device 86. As a result, the likelihood of erroneously coupling a terminal block 106 to an I/O module 62 is eliminated because the key inserts 102 within the slots 104 prevent the terminal block 106 from being pushed into the receptacle 88 and the corresponding circuit device 84. Moreover, by preventing incorrect terminal blocks 106 connecting to certain I/O modules 62, the present embodiments avoid instances in which users may damage the respective I/O module 62 by having improper or errant electrical connections being made to the respective I/O module 62.

The techniques presented and claimed herein are referenced and applied to material objects and concrete examples of a practical nature that demonstrably improve the present technical field and, as such, are not abstract, intangible, or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

While only certain features of the embodiments have been illustrated and described herein, many modifications and changes will occur to those skilled in the art. It is, therefore, to be understood that the appended claims are intended to cover all such modifications and changes as fall within the true spirit of the present embodiments describe herein.
**The following is a list of further preferred embodiments of the invention:**
Embodiment 1. A system, comprising:
   a terminal block having a plurality of slots on a first side of the terminal block, wherein each of the plurality of slots is configured to receive an insert; and
   an input/output (I/O) device comprising a circuit, wherein the circuit comprises one or more indentations configured to receive one or more inserts positioned in one or more slots of the plurality of slots.
Embodiment 2. The system of embodiment 1, wherein the terminal block comprises a first coupling element configured to couple to a second coupling element part of a base of the I/O device.
Embodiment 3. The system of embodiment 2, wherein the first coupling element comprises a rotational coupling element and wherein the second coupling element comprises a cylindrical coupling element.
Embodiment 4. The system of embodiment 3, wherein the rotational coupling element is configured to rotate about an axis that corresponds to the cylindrical coupling element.
Embodiment 5. The system of embodiment 1, wherein a second side of the terminal block comprises a plurality of terminals configured to receive one or more electrical connectors configured to electrically couple to the circuit via one or more additional electrical connectors disposed on the circuit.
Embodiment 6. The system of embodiment 2, wherein the one or more indentations are positioned adjacent to the one or more additional electrical connectors.
Embodiment 7. The system of embodiment 1, comprising a key component comprising a body portion and a plurality of inserts coupled to the body portion.
Embodiment 8. The system of embodiment 7, wherein the each insert of the plurality of inserts is configured to disconnect from the body portion of the key component after being placed in one slot of the plurality of slots and the key component being turned.
Embodiment 9. A terminal block, comprising:
   a first side comprising a plurality of terminals configured to receive one or more electrical connectors; and
   a second side opposite to the first side, wherein the second side comprises a plurality of slots, wherein each slot of the plurality of slots is configured to receive an insert, wherein the terminal block is configured to couple to a housing of an input/output (I/O) device via the second side, and wherein the I/O device comprises a circuit comprising an indentation configured to receive the insert when the terminal block is coupled to the housing.
Embodiment 10. The terminal block of embodiment 9, comprising a rotational coupling element configured to couple to a cylindrical coupling element.
Embodiment 11. The terminal block of embodiment 10, wherein the terminal block is configured to rotate about an axis that corresponds to the cylindrical coupling element via the rotational coupling element.
Embodiment 12. The terminal block of embodiment 9, wherein the insert comprises a square or rectangular shape.
Embodiment 13. The terminal block of embodiment 9, wherein the one or more electrical connectors are configured to electrically couple to the circuit when the terminal block is coupled to the housing.
Embodiment 14. A method, comprising:
   positioning one or more inserts into one or more slots of a terminal block configured to couple to a housing of an input/output (I/O) device;
   coupling a first coupling element of the terminal block to a second coupling element of a base of the I/O device; and
   rotating the terminal block along an axis that corresponds to the second coupling element, wherein the terminal block is configure to couple to the housing and a circuit of the I/O
   device via the rotation, wherein the circuit comprises one or more indentations configured to receive the one or more inserts positioned in the one or more slots of the terminal block.
Embodiment 15. The method of embodiment 14, wherein the circuit comprises a plurality of electrical connectors configured to electrically couple to a plurality of terminals of the terminal block.
Embodiment 16. The method of embodiment 15, wherein the plurality of terminals is disposed on a first side of the terminal block and the one or more slots are disposed on a second side of the terminal block opposite the first side.
Embodiment 17. The method of embodiment 14, comprising coupling the housing of the I/O device to the base of the I/O device before rotating the terminal block.
Embodiment 18. The method of embodiment 17, wherein the circuit comprises one or more protrusions configured to couple to one or more additional slots disposed on the base.
Embodiment 19. The method of embodiment 14, comprising coupling the base to a rail structure.
Embodiment 20. The method of embodiment 19, wherein the rail structure comprises a DIN rail.

## Claims

1. A system, comprising:
a terminal block having a plurality of slots on a first side of the terminal block, wherein each of the plurality of slots is configured to receive an insert; and
an input/output (I/O) device comprising a circuit, wherein the circuit comprises one or more indentations configured to receive one or more inserts positioned in one or more slots of the plurality of slots.

2. The system of claim 1, wherein the terminal block comprises a first coupling element configured to couple to a second coupling element part of a base of the I/O device.

3. The system of claim 2, wherein the first coupling element comprises a rotational coupling element and wherein the second coupling element comprises a cylindrical coupling element.

4. The system of claim 3, wherein the rotational coupling element is configured to rotate about an axis that corresponds to the cylindrical coupling element.

5. The system of one of claims 1 to 4, wherein a second side of the terminal block comprises a plurality of terminals configured to receive one or more electrical connectors configured to electrically couple to the circuit via one or more additional electrical connectors disposed on the circuit.

6. The system of claim 2, wherein the one or more indentations are positioned adjacent to the one or more additional electrical connectors.

7. The system of one of claims 1 to 6, comprising a key component comprising a body portion and a plurality of inserts coupled to the body portion, and/or
wherein the each insert of the plurality of inserts is configured to disconnect from the body portion of the key component after being placed in one slot of the plurality of slots and the key component being turned.

8. A terminal block, comprising:
a first side comprising a plurality of terminals configured to receive one or more electrical connectors; and
a second side opposite to the first side, wherein the second side comprises a plurality of slots, wherein each slot of the plurality of slots is configured to receive an insert, wherein
the terminal block is configured to couple to a housing of an input/output (I/O) device via the second side, and wherein the I/O device comprises a circuit comprising an indentation configured to receive the insert when the terminal block is coupled to the housing.

9. The terminal block of claim 8, comprising a rotational coupling element configured to couple to a cylindrical coupling element, and/or
wherein the terminal block is configured to rotate about an axis that corresponds to the cylindrical coupling element via the rotational coupling element.

10. The terminal block of one of claims 8 or 9, wherein the insert comprises a square or rectangular shape.

11. The terminal block of one of claims 8 to 10, wherein the one or more electrical connectors are configured to electrically couple to the circuit when the terminal block is coupled to the housing.

12. A method, comprising:
positioning one or more inserts into one or more slots of a terminal block configured to couple to a housing of an input/output (I/O) device;
coupling a first coupling element of the terminal block to a second coupling element of a base of the I/O device; and
rotating the terminal block along an axis that corresponds to the second coupling element,
wherein the terminal block is configure to couple to the housing and a circuit of the I/O device via the rotation, wherein the circuit comprises one or more indentations configured to receive the one or more inserts positioned in the one or more slots of the terminal block.

13. The method of claim 12, wherein the circuit comprises a plurality of electrical connectors configured to electrically couple to a plurality of terminals of the terminal block, and/or wherein the plurality of terminals is disposed on a first side of the terminal block and the one or more slots are disposed on a second side of the terminal block opposite the first side.

14. The method of one of claims 12 or 13, comprising coupling the housing of the I/O device to the base of the I/O device before rotating the terminal block, and/or
wherein the circuit comprises one or more protrusions configured to couple to one or more additional slots disposed on the base.

15. The method of one of claims 12 to 14, comprising coupling the base to a rail structure, and/or
wherein the rail structure comprises a DIN rail.
